# EUROPÄISCHE PATENTSCHRIFT

(11) **EP 3 206 238 B1**
(45) Veröffentlichungstag und Bekanntmachung des Hinweises auf die Patenterteilung: **18.12.2019**
(21) Anmeldenummer: 17159663.8
(22) Anmeldetag: 04.09.2008
(51) Int. Cl.: H01L 33/38, H01L 33/14, H01L 33/40

(54) **LICHTEMITTIERENDE DÜNNFILM-DIODE MIT EINER SPIEGELSCHICHT UND VERFAHREN ZU DEREN HERSTELLUNG**
LIGHT EMITTING THIN-FILM DIODE HAVING A MIRROR LAYER AND METHOD FOR THE PRODUCTION THEREOF
DIODE ÉLECTROLUMINESCENTE À COUCHES MINCES DOTÉE D'UNE COUCHE MIROIR ET SON PROCÉDÉ DE FABRICATION

(30) Priorität: 28.09.2007 DE 102007046519
(43) Veröffentlichungstag der Anmeldung: 16.08.2017
(62) Teilanmeldung aus: 08801300.8
(73) Patentinhaber: OSRAM Opto Semiconductors GmbH, 93055 Regensburg (DE)
(72) Erfinder: HAHN, Berthold, 93155 Hemau (DE); WEIMAR, Andreas, 93055 Regensburg (DE); BAUR, Johannes, 93051 Regensburg (DE); SABATHIL, Matthias, 93059 Regensburg (DE); PLAINE, Glenn-Yves, 69002 Lyon (FR)
(74) Vertreter: Epping - Hermann - Fischer

(56) Entgegenhaltungen:
- WO-A-2007/036164
- DE-A1-102005 003 460
- JP-B2- 2 937 692
- US-A1- 2006 011 935
- US-A1- 2007 145 391

## Beschreibung

Die Erfindung betrifft eine Dünnfilm-LED mit einer Spiegelschicht gemäß dem Patentanspruch 1 und ein Verfahren zu dessen Herstellung gemäß dem Patentanspruch 12.

Diese Patentanmeldung beansprucht die Priorität der deutschen Patentanmeldung 10 2007 046 519.1.

Die Druckschrift DE 10 2005 003460 A1 offenbart eine lichtemittierende Vorrichtung mit einer Stromaufweitunggstruktur und einer Kontaktschicht mit einer Ausnehmung.

Die Druckschrift WO 2007/036164 A1 offenbart eine lichtemittierende Vorrichtung mit einer aktiven Schicht zwischen einer oberen und einer unteren Kontaktschicht, welche sich in ihrer Form voneinander unterscheiden.

Der Erfindung liegt die Aufgabe zugrunde, eine hinsichtlich der Strahlungsauskopplung effiziente Dünnfilm-LED, die sich insbesondere durch eine verminderte Absorption von Strahlung in den Kontaktschichten auszeichnet, und ein Verfahren zu dessen Herstellung anzugeben.

Diese Aufgabe wird durch eine Dünnfilm-LED mit den Merkmalen des Patentanspruchs 1 und durch ein Verfahren zu deren Herstellung mit den Merkmalen des Patentanspruchs 9 gelöst. Vorteilhafte Ausgestaltungen und Weiterbildungen der Erfindung sind Gegenstand der abhängigen Patentansprüche.

Eine erfindungsgemäße Dünnfilm-LED umfasst eine Barriereschicht, eine der Barriereschicht nachfolgende erste Spiegelschicht, einen der ersten Spiegelschicht nachfolgenden Schichtstapel, der mindestens eine aktive Schicht aufweist, die elektromagnetische Strahlung emittiert und eine dem Schichtstapel nachfolgende Kontaktstruktur. Die Kontaktstruktur ist auf einer Strahlungsaustrittsfläche der Dünnfilm-LED angeordnet und weist eine Kontaktfläche auf. Die erste Spiegelschicht weist in einem der Kontaktfläche der Kontaktstruktur gegenüberliegenden Bereich eine Aussparung auf, die größer als die Kontaktfläche der Kontaktstruktur ist.

Die erste Spiegelschicht ist also derart strukturiert, dass der Kontaktfläche der Kontaktstruktur in vertikaler Richtung ein nicht von der ersten Spiegelschicht bedeckter Bereich der Barriereschicht gegenüber liegt, der größer als die Kontaktfläche der Kontaktstruktur ist.

Bei einer Ausgestaltung der Dünnfilm-LED kann die Barriereschicht im Bereich der Aussparung der ersten Spiegelschicht direkt an eine der Kontaktstruktur gegenüberliegende Grenzfläche des Schichtstapels angrenzen.

Die Kontaktstruktur kann ein Bondpad und/oder mehrere mit dem Bondpad elektrisch verbundene Kontaktstege umfassen, um eine bessere Stromaufweitung zu erzielen. Durch eine Anordnung mit mehreren mit dem Bondpad elektrisch leitend verbundenen Kontaktstegen kann eine vergleichsweise homogene Stromverteilung in der Dünnfilm-LED erreicht werden.

Unter der Kontaktfläche der Kontaktstruktur wird im Folgenden bei Verwendung eines Bondpads eine Hauptfläche des Bondpads verstanden. Bei Verwendung eines Bondpads mit mehreren mit dem Bondpad elektrisch verbundenen Kontaktstegen wird im Folgenden unter der Kontaktfläche die gesamte von dem Bondpad und den Kontaktstegen gebildete Hauptfläche verstanden.

Die erste Spiegelschicht kann als reflektierende Kontaktschicht ausgebildet sein, wobei die erste Spiegelschicht in einem der Kontaktfäche der Kontaktstruktur gegenüberliegenden Bereich eine Aussparung aufweist. Die von der aktiven Schicht aus gesehen der Strahlungsaustrittsfläche gegenüberliegende erste Spiegelschicht ist also derart strukturiert, dass der Kontaktstruktur in vertikaler Richtung von der aktiven Schicht aus gesehen ein nicht von der ersten Spiegelschicht bedeckter Bereich der Hauptfläche des Schichtstapels gegenüber liegt.

Da der ausgesparte Bereich keine als reflektierende Kontaktschicht wirkende erste Spiegelschicht aufweist, entsteht in der Aussparung kein elektrischer Kontakt an dem angrenzenden Schichtstapel. Dadurch wird der Stromfluss zwischen der Kontaktstruktur auf der Strahlungsaustrittsfläche und der Aussparung in dem Bereich des Schichtstapels, der in vertikaler Richtung unterhalb und unmittelbar neben der Kontaktfläche der Kontaktstruktur liegt, vermindert. Die Strahlungserzeugung in diesem Bereich der aktiven Schicht ist somit vermindert, wodurch vorteilhaft die Absorption von Strahlung innerhalb der Kontaktstruktur reduziert wird. Weiterhin wird durch die Aussparung der ersten Spiegelschicht der Anteil der emittierten Strahlung, der von der ersten Spiegelschicht in Richtung der Kontaktstruktur reflektiert wird, vermindert. Auf diese Weise wird die Absorption von Strahlung in der Kontaktstruktur weiter vermindert. Die Effizienz der Dünnfilm-LED wird dadurch vorteilhaft erhöht.

Die LED ist erfindungsgemäß als Dünnfilm-LED ausgeführt. Bei einer Dünnfilm-LED ist das Herstellungssubstrat, auf dem der Schichtstapel für die LED hergestellt, insbesondere abgeschieden wurde, bereichsweise oder vollständig entfernt. Das Herstellungssubstrat ist vorzugsweise das Aufwachssubstrat, auf dem der Schichtstapel epitaktisch gewachsen ist. Das Herstellungssubstrat ist vorzugsweise derart entfernt, dass die dem Herstellungssubstrat zugewandte Oberfläche des Schichtstapels einer weiteren Prozessierung zugänglich ist.

Vorzugsweise ist die laterale Ausdehnung der Aussparung der ersten Spiegelschicht um 5 µm bis 20 µm größer als die laterale Ausdehnung der Kontaktfläche der Kontaktstruktur.

Durch die Aussparung kann eine Verminderung der Stromdichte in dem Bereich der aktiven Schicht, der in vertikaler Richtung unterhalb der Kontaktfläche der Kontaktstruktur und in dem Bereich, der in vertikaler Richtung unmittelbar neben der Kontaktfläche der Kontaktstruktur liegt, erreicht werden. Das bedeutet, dass eine räumliche Trennung zwischen Bereichen der aktiven Schicht, in denen Lichterzeugung stattfindet, und Bereichen der aktiven Schicht, in denen nur eine geringe oder vorzugsweise keine Lichterzeugung stattfindet, erreicht wird. Die Bereiche der geringen Lichterzeugung liegen direkt unterhalb und unmittelbar neben der Kontaktfläche der Kontaktstruktur, die für die von der aktiven Schicht emittierte Strahlung absorbierend wirkt. Durch die räumliche Trennung wird der Anteil der von der aktiven Schicht emittierten Strahlung, der von der Kontaktstruktur absorbiert wird, reduziert. Die Effizienz der Dünnfilm-LED erhöht sich dadurch mit Vorteil.

Eine gegenüber der lateralen Ausdehnung der Kontaktfläche um über 20 µm vergrößerte laterale Ausdehnung der Aussparung ist alternativ auch möglich. Dadurch wird die Lichtauskopplung der Dünnfilm-LED zwar nicht nachteilig beeinflusst, allerdings ergibt sich mit einer über 20 µm vergrößerten lateralen Ausdehnung der Aussparung eine erhöhte Diodenspannung, die eine reduzierte Effizienz der aktiven Schicht zur Folge hat.

Eine weitere Ausgestaltung der Erfindung sieht vor, dass eine Grenzfläche des Schichtstapels, die der Strahlungsaustrittsfläche gegenüber liegt, im Bereich der Aussparung derart verändert ist, dass sich der Kontaktwiderstand zwischen dem Schichtstapel und dem ausgesparten Bereich der ersten Spiegelschicht erhöht.

Eine weitere bevorzugte Ausgestaltung sieht vor, dass die Grenzfläche des Schichtstapels, die der Strahlungsaustrittsfläche gegenüber liegt, im Bereich der Aussparung derart verändert ist, dass die Grenzfläche des Schichtstapels im Bereich der Aussparung nicht elektrisch leitend ist.

Da in dem ausgesparten Bereich der ersten Spiegelschicht der Kontaktwiderstand zwischen dem Schichtstapel und dem ausgesparten Bereich der ersten Spiegelschicht erhöht und/oder die Grenzfläche des Schichtstapels im Bereich der Aussparung nicht elektrisch leitend ist, ist der Stromfluss und somit die Lichterzeugung in der aktiven Schicht in Bereichen unterhalb und direkt neben der Kontaktstruktur vermindert, wodurch sich eine Absorption der von der aktiven Schicht emittierten Strahlung in der Kontaktstruktur reduziert.

Die Grenzfläche des Schichtstapels ist im Bereich der Aussparung derart verändert, dass sich der Kontaktwiderstand zwischen dem Schichtstapel und dem ausgesparten Bereich der ersten Spiegelschicht erhöht, besonders bevorzugt ist die Grenzfläche des Schichtstapels im Bereich der Aussparung nicht elektrisch leitend, wobei die Aussparung der ersten Spiegelschicht erfindungsgemäß eine zweite Spiegelschicht aufweist.

Durch die veränderte Grenzfläche des Schichtstapels vermindert sich die Stromdichte in dem Bereich der aktiven Schicht, der in vertikaler Richtung unterhalb und unmittelbar neben der Kontaktfläche der Kontaktstruktur liegt, so dass weniger Strahlung unterhalb der Kontaktfläche der Kontaktstruktur erzeugt wird. Durch die zweite Spiegelschicht, die sich in der Aussparung der ersten Spiegelschicht und somit auf der Grenzfläche des Schichtstapels befindet, wird der Anteil der emittierten Strahlung, der in Richtung der Aussparung der ersten Spiegelschicht reflektiert wird, an der zweiten Spiegelschicht in Richtung der Strahlungsaustrittsfläche reflektiert. Dadurch kann dieser Anteil der emittierten Strahlung an der Strahlungsaustrittsfläche der Dünnfilm-LED ausgekoppelt werden. Mit Vorteil erhöht sich auf diese Weise die Effizienz der Dünnfilm-LED.

Eine weitere bevorzugte Ausgestaltung der Erfindung sieht vor, dass eine dem Schichtstapel zugewandte Hauptfläche der Kontaktstruktur eine reflektierende Schicht aufweist. Besonders bevorzugt enthält die reflektierende Schicht Ag, Al und/oder Pt.

Durch die reflektierende Schicht auf der dem Schichtstapel zugewandten Hauptfläche der Kontaktstruktur wird der Anteil der emittierten Strahlung, der von der zweiten Spiegelschicht in Richtung der Hauptfläche der Kontaktstruktur reflektiert wird, zurück in Richtung der ersten oder der zweiten Spiegelschicht reflektiert. Dieser Anteil der emittierten Strahlung wird wiederum an der ersten oder der zweiten Spiegelschicht in Richtung der Strahlungsaustrittsfläche der Dünnfilm-LED reflektiert. Auf diese Weise vermindert sich die Absorption von Strahlung in der Kontaktstruktur, besonders bevorzugt wird keine emittierte Strahlung von der Kontaktstruktur absorbiert. Dadurch erhöht sich die Effizienz der Dünnfilm-LED vorteilhaft.

Bevorzugt ist die Strahlungsaustrittsfläche des Schichtstapels aufgeraut. Durch die Aufrauung der Strahlungsaustrittsfläche erniedrigt sich die Reflektivität an der Grenzfläche zwischen Schichtstapel und einem den Schichtstapel umgebenes Medium. Dadurch wird ein höherer Anteil der Strahlung, der auf die Grenzfläche trifft, aus dem Schichtstapel ausgekoppelt. Somit verringert sich der Anteil der von der aktiven Schicht emittierten Strahlung, der an der Strahlungsaustrittsfläche in Richtung der aktiven Schicht zurück reflektiert wird. Die Effizienz der Dünnfilm-LED erhöht sich mit Vorteil.

Eine weitere Ausgestaltung der Erfindung sieht vor, dass die Bereiche des Schichtstapels, auf denen die Kontaktstruktur angeordnet ist, eine geringere Schichthöhe aufweisen als Bereiche des Schichtstapels, auf denen keine Kontaktstruktur angeordnet ist. Dadurch kann eine weitere Intensitätssteigerung der von dem Schichtstapel emittierten Strahlung erreicht werden.

Bevorzugt weist der Schichtstapel, auf dem keine Kontaktstruktur aufgebracht ist, eine Schichthöhe zwischen 4 µm und 8 µm, besonders bevorzugt von 6 µm auf. Die Bereiche des Schichtstapels, auf die die Kontaktstruktur aufgebracht ist, weisen bevorzugt eine Schichthöhe zwischen 50 nm und 3,5 µm, besonders bevorzugt im Bereich zwischen 100 nm und 2 µm auf.

Vorzugsweise weist mindestens eine der Seitenflächen des Schichtstapels eine weitere reflektierende Schicht auf. Dadurch wird der Anteil der emittierten Strahlung, der ohne die mindestens eine weitere reflektierende Schicht aus dem Schichtstapel lateral ausgekoppelt werden würde, in Richtung des Schichtstapels reflektiert. Durch weitere Reflektionen im Schichtstapel kann dieser Anteil der emittierten Strahlung in Richtung der Strahlungsaustrittsfläche reflektiert und ausgekoppelt werden. Dadurch erhöht sich die Effizienz der Dünnfilm-LED weiter vorteilhaft.

Bevorzugt enthält die weitere reflektierende Schicht, die an mindestens einer der Seitenfläche des Schichtstapels aufgebracht ist, Ag, Al und/oder Pt.

Bei einer weiteren vorteilhaften Ausgestaltung der Erfindung ist auf mindestens einem Teilbereich der Strahlungsaustrittsfläche der Dünnfilm-LED eine Lumineszenzkonversionsschicht aufgebracht. Die Lumineszenzkonversionsschicht enthält zumindest einen Lumineszenzkonversionsstoff, der zur Wellenlängenkonversion zumindest eines Teils der von der Dünnfilm-LED emittierten Strahlung zu größeren Wellenlängen hin geeignet ist. Auf diese Weise kann insbesondere mit einer Dünnfilm-LED, die ultraviolette oder blaue Strahlung emittiert, durch Wellenlängenkonversion eines Teils der emittierten Strahlung in den komplementären Spektralbereich, beispielsweise den gelben Spektralbereich, Weißlicht erzeugt werden. Geeignete Lumineszenzkonversionsstoffe, wie zum Beispiel YAG:Ce, sind aus der WO 98/12757 bekannt, deren Inhalt hiermit insbesondere in Bezug auf Leuchtstoffe durch Referenz aufgenommen wird.

Ein weiterer Vorteil einer auf der Strahlungsaustrittsfläche aufgebrachten Lumineszenzkonversionsschicht ergibt sich dadurch, dass sich die Effizienz der Dünnfilm-LED vorteilhaft verbessert, da sich durch die Lumineszenzkonversionsschicht die Anzahl der Rückreflektionen der von der aktiven Schicht emittierten Strahlung in Richtung des Schichtstapels weiter reduziert. Das beruht darauf, dass bevorzugt der Brechungsindexunterschied zwischen Schichtstapel und Lumineszenzkonversionsschicht kleiner ist als der Brechungsindexunterschied zwischen Schichtstapel und das dem Schichtstapel umgebene Medium. Durch einen niedrigeren Brechungsindexunterschied an der Strahlungsaustrittsfläche erhöht sich der Anteil der Strahlung, der aus dem Schichtstapel ausgekoppelt wird.

Bevorzugt basiert der Schichtstapel der Dünnfilm-LED auf einem Nitrid-Verbindungshalbleiter. "Auf Nitrid-Verbindungshalbleitern basierend" bedeutet im vorliegenden Zusammenhang, dass die aktive Epitaxie-Schichtenfolge oder zumindest eine Schicht davon ein Nitrid-III/V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Die erste und/oder zweite Spiegelschicht enthält vorzugsweise Al und/oder Pt, besonders bevorzugt Ag. Die Barriereschicht enthält TiWN.

Die aktive Schicht der Dünnfilm-LED umfasst bevorzugt einen pn-Übergang, eine Doppelheterostruktur, einen Einfach-Quantentopf oder besonders bevorzugt eine Mehrfach-Quantentopfstruktur (MQW) zur Strahlungserzeugung. Die Bezeichnung Quantentopfstruktur beinhaltet hierbei keine Angabe über die Dimensionalität der Quantisierung. Sie umfasst somit u.a. Quantentröge, Quantendrähte und Quantenpunkte und jede Kombination dieser Strukturen.

Ein Verfahren zur Herstellung einer erfindungsgemäßen Dünnfilm-LED umfasst folgende Verfahrensschritte:
- Bereitstellen eines Aufwachssubstrats,
- epitaktisches Aufwachsen eines Schichtstapels, der geeignet ist, elektromagnetische Strahlung zu erzeugen,
- Aufbringen einer ersten Spiegelschicht, die eine Aussparung in einem Bereich, der einem vorgesehenen Bereich einer Kontaktstruktur gegenüber liegt, aufweist,
- Aufbringen einer Barriereschicht auf der ersten Spiegelschicht,
- Ablösen des Schichtstapels von dem Aufwachssubstrat,
- Aufbringen einer Kontaktstruktur, die eine Kontaktfläche aufweist, auf der der ersten Spiegelschicht gegenüberliegenden Seite des Schichtstapels, wobei die Kontaktstruktur in einem der Aussparung der ersten Spiegelschicht gegenüberliegenden Bereich aufgebracht wird, und die Kontaktfläche der Kontaktstruktur kleiner als die Aussparung der ersten Spiegelschicht ist.

Die erste Spiegelschicht wird also derart strukturiert, dass der Kontaktfläche der Kontaktstruktur in vertikaler Richtung ein nicht von der ersten Spiegelschicht bedeckter Bereich der Barriereschicht gegenüber liegt, der größer ist als die Kontaktfläche der Kontaktstruktur. Die erste Spiegelschicht ist bevorzugt als reflektierende Kontaktschicht ausgebildet, die vorzugsweise einen ohmschen Kontakt zum angrenzenden Schichtstapel herstellt.

Durch die Aussparung ist die Stromdichte in einem Bereich der aktiven Schicht, der in vertikaler Richtung unterhalb und unmittelbar neben der Kontaktfläche der Kontaktstruktur liegt, vermindert, so dass weniger Strahlung von der aktiven Schicht unterhalb der Kontaktfläche der Kontaktstruktur erzeugt wird. Weiterhin wird durch die Aussparung der ersten Spiegelschicht der Anteil der emittierten Strahlung, der von der ersten Spiegelschicht in Richtung der Kontaktfläche der Kontaktstruktur reflektiert wird, vermindert. Auf diese Weise wird die Absorption von Strahlung in der Kontaktstruktur vermindert. Die Effizienz der Dünnfilm-LED wird dadurch vorteilhaft erhöht.

Eine vorteilhafte Weiterbildung des Verfahrens sieht vor, dass vor Aufbringen der Barriereschicht die Grenzfläche des Schichtstapels in dem Bereich der Aussparung der ersten Spiegelschicht durch einen Plasmaprozess beschädigt wird. Insbesondere kann die Grenzfläche des Schichtstapels in dem Bereich der Aussparung der ersten Spiegelschicht durch einen Sputterprozess beschädigt werden. Bevorzugt wird die Grenzfläche des Schichtstapels in dem Bereich der Aussparung der ersten Spiegelschicht derart beschädigt, dass die Grenzfläche des Schichtstapels in diesem Bereich nicht elektrisch leitend ist.

Da die Grenzfläche des Schichtstapels in der Aussparung bevorzugt nicht elektrisch leitend ist, ist die Stromdichte der aktiven Schicht im Bereich der Aussparung vermindert, so dass weniger Strahlung von der aktiven Schicht unterhalb der Kontaktfläche der Kontaktstruktur erzeugt wird. Dadurch reduziert sich mit Vorteil der Anteil der von der aktiven Schicht emittierten Strahlung, der von der Kontaktstruktur absorbiert wird.

Das erfindungegemäße Verfahren sieht vor, dass vor Aufbringen der Barriereschicht eine zweite Spiegelschicht auf die beschädigte Grenzfläche des Schichtstapels in der Aussparung der ersten Spiegelschicht aufgebracht wird. Durch die zweite Spiegelschicht wird der Anteil der emittierten Strahlung, der in Richtung der Aussparung der ersten Spiegelschicht reflektiert wird, an der zweiten Spiegelschicht in Richtung Strahlungsaustrittsfläche reflektiert. Dadurch kann dieser Anteil der emittierten Strahlung an der Strahlungsaustrittsfläche der Dünnfilm-LED ausgekoppelt werden. Die Effizienz der Dünnfilm-LED erhöht sich vorteilhaft.

Bei zumindest einer weiteren Ausgestaltung wird die Strahlungsaustrittsfläche des Schichtstapels vor Aufbringen der Kontaktstruktur aufgeraut. Durch die Aufrauung der Strahlungsaustrittsfläche erniedrigt sich die Reflektivität an der Strahlungsaustrittsfläche, wodurch sich die Anzahl an Rückreflektionen an der Strahlungsaustrittsfläche in Richtung der aktiven Schicht verringert. Dadurch kann ein größerer Anteil der Strahlung, die auf die Strahlungsaustrittsfläche trifft, aus der Dünnfilm-LED ausgekoppelt werden. Die Effizienz der Dünnfilm-LED erhöht sich mit Vorteil.

Bevorzugt sieht eine weitere Ausgestaltung des Verfahrens vor, dass vor Aufbringen der Kontaktstruktur auf den Schichtstapel eine reflektierende Schicht auf die Teilbereiche des Schichtstapels aufgebracht wird, die für die Kontaktstruktur vorgesehen sind. Dadurch wird der Anteil der Strahlung, der von der aktiven Schicht der Dünnfilm-LED ausgesandt wird und ohne die zusätzliche reflektierende Schicht von der Kontaktstruktur absorbiert werden würde, in Richtung der ersten oder der zweiten Spiegelschicht und von dieser wieder in Richtung der Strahlungsaustrittsfläche reflektiert, so dass die Strahlung aus der Dünnfilm-LED ausgekoppelt werden kann. Dadurch erhöht sich die Effizienz der Dünnfilm-LED weiter vorteilhaft.

Eine weitere vorteilhafte Weiterbildung des Verfahrens sieht vor, dass Bereiche des Schichtstapels, auf die die Kontaktstruktur aufgebracht ist, vor Aufbringen der Kontaktstruktur trockenchemisch behandelt werden. Dadurch ergeben sich Bereiche des Schichtstapels, auf denen die Kontaktstruktur angeordnet ist, die eine geringere Schichthöhe aufweisen als Bereiche des Schichtstapels, auf denen keine Kontaktstruktur angeordnet ist. Dadurch kann eine weitere Intensitätssteigerung der von der Dünnfilm-LED emittierten Strahlung erreicht werden.

Bevorzugt sieht eine Weiterbildung des Verfahrens vor, dass zusätzlich auf mindestens eine der Seitenflächen des Schichtstapels eine weitere reflektierende Schicht aufgebracht wird. Dadurch wird der Anteil der Strahlung, der von der aktiven Schicht der Dünnfilm-LED lateral ausgesandt wird, in Richtung des Schichtstapels zurück reflektiert. Durch weitere Reflektionen im Schichtstapel kann dieser Anteil der emittierten Strahlung in Richtung der Strahlungsaustrittsfläche reflektiert und ausgekoppelt werden. Dadurch erhöht sich die Effizienz der Dünnfilm-LED weiter vorteilhaft.

Weitere Merkmale, Vorteile, bevorzugte Ausgestaltungen und Zweckmäßigkeiten der Dünnfilm-LED ergeben sich aus den im Folgenden in Verbindung mit den Figuren 1 bis 4 erläuterten Ausführungsbeispielen. Es zeigen:
Figur 1 einen schematischen Querschnitt eines ersten Ausführungsbeispiels einer erfindungsgemäßen Dünnfilm-LED,
Figur 2 einen schematischen Querschnitt eines zweiten Ausführungsbeispiels einer erfindungsgemäßen Dünnfilm-LED,
Figur 3 einen schematischen Querschnitt eines dritten Ausführungsbeispiels einer erfindungsgemäßen Dünnfilm-LED, und
Figur 4 einen schematischen Querschnitt eines vierten Ausführungsbeispiels einer erfindungsgemäßen Dünnfilm-LED.

Gleiche oder gleichwirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

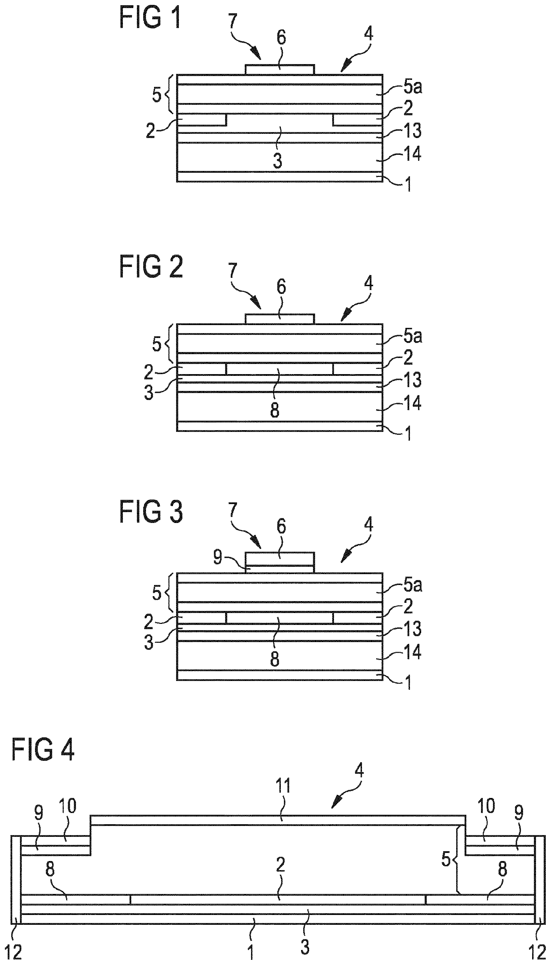

Die in Figur 1 dargestellte Dünnfilm-LED stellt ein erstes Ausführungsbeispiel einer Dünnfilm-LED dar. Die Dünnfilm-LED umfasst eine Barriereschicht 3, eine nachfolgende erste Spiegelschicht 2 und einen darauf angeordneten Schichtstapel 5. Der Schichtstapel 5 weist eine aktive Schicht 5a auf, die bei Betrieb elektromagnetische Strahlung emittiert. Eine Kontaktstruktur 6, die als Bondpad ausgebildet ist, ist auf einer Strahlungsaustrittsfläche 4 angeordnet und weist eine Kontaktfläche 7 auf. Die erste Spiegelschicht 2 weist in einem der Kontaktfläche 7 des Bondpads 6 gegenüberliegenden Bereich eine Aussparung auf, wobei die Aussparung der ersten Spiegelschicht 2 größer als die Kontaktfläche 7 des Bondpads 6 ist.

Die erste Spiegelschicht 2 ist also derart strukturiert, dass in vertikaler Richtung der Kontaktfläche 7 des Bondpads 6 ein nicht von der ersten Spiegelschicht 2 bedeckter Bereich der Barriereschicht 3 gegenüber liegt.

Die erste Spiegelschicht 2 ist als reflektierende Kontaktschicht ausgebildet, die einen dem Bondpad 6 von der aktiven Schicht 5a aus gesehen gegenüberliegenden zweiten elektrischen Kontakt der Dünnfilm-LED ausbildet.

Die Dünnfilm-LED basiert bevorzugt auf einem Nitridverbindungshalbleiter. Die erste Spiegelschicht 2 enthält vorzugsweise Ag. Die erste Spiegelschicht 2 ist durch eine Barriereschicht 3, die bevorzugt TiWN enthält, gekapselt, um Ag-Migration zu verhindern.

Die Aussparung der ersten Spiegelschicht 2, und somit der reflektierenden Kontaktschicht, hat den Vorteil, dass die Stromdichte in einem Bereich der aktiven Schicht 5a, der in vertikaler Richtung unterhalb und unmittelbar neben der Kontaktfläche 7 des Bondpads 6 liegt, vermindert ist, so dass weniger Strahlung unterhalb und unmittelbar neben der Kontaktfläche 7 des Bondpads 6 erzeugt wird, wodurch sich der Anteil der von der aktiven Schicht 5a emittierten Strahlung, der von dem Bondpad 6 absorbiert wird, reduziert. Ferner wird durch die Aussparung der ersten Spiegelschicht 2 der Anteil der emittierten Strahlung, der von der ersten Spiegelschicht 2 in Richtung des Bondpads 6 reflektiert wird, weiter vermindert. Auf diese Weise wird die Absorption von Strahlung in dem Bondpad 6 vermindert. Die Effizienz der Dünnfilm-LED wird dadurch vorteilhaft erhöht.

Vorzugsweise ist die laterale Ausdehnung der Aussparung um 5 µm bis 20 µm größer als die laterale Ausdehnung der Kontaktfläche 7 des Bondpads 6. Dadurch wird die Stromdichte in einem Bereich, der unterhalb und unmittelbar neben dem Bondpad liegt, das als Absorber wirkt, unterdrückt, wodurch sich der Anteil der durch die Strahlungsaustrittsfläche 4 ausgekoppelten Strahlung erhöht. Eine gegenüber der lateralen Ausdehnung der Kontaktfläche 7 um über 20 µm vergrößerte laterale Ausdehnung der Aussparung ist alternativ auch möglich. Allerdings ergibt sich dabei eine erhöhte Diodenspannung und somit eine reduzierte Effizienz der aktiven Schicht 5a.

An einer der Strahlungsaustrittsfläche 4 gegenüberliegenden Seite des Schichtstapels 5 kann die Dünnfilm-LED auf einem Träger 14 befestigt sein. Beispielsweise ist der Schichtenstapel 5 mittels einer Verbindungsschicht 13, die insbesondere eine Lotschicht sein kann, auf dem Träger 14 befestigt. Der Träger 14 ist beispielsweise eine Leiterplatte, insbesondere eine gedruckte Leiterplatte (Printed Circuit Board). Ferner kann der Träger 14 aus einer Keramik, die insbesondere Aluminiumnitrid enthalten kann, gebildet sein. Auch Träger 14 aus einem Halbleitermaterial, wie beispielsweise Ge- oder GaAs-Träger, können verwendet werden. Eine von dem Schichtstapel 5 abgewandte Rückseite des Trägers 14 kann beispielsweise mit einer elektrischen Kontaktschicht 1 versehen sein, die einen dem Bondpad 6 von der aktiven Schicht 5a aus gesehen gegenüberliegenden zweiten elektrischen Kontakt der Dünnfilm-LED ausbildet.

Durch die Barriereschicht 3 wird insbesondere eine Diffusion von Material der Verbindungsschicht 13, die beispielsweise eine Lotschicht ist, in die erste Spiegelschicht 2 verhindert, durch die insbesondere die Reflektion der ersten Spiegelschicht 2 beeinträchtigt werden könnte.

Die in Figur 2 dargestellte Dünnfilm-LED weist im Gegensatz zu der Dünnfilm-LED aus Figur 1 in der Aussparung der ersten Spiegelschicht 2 eine zweite Spiegelschicht 8 auf, so dass die Barriereschicht 3, die bevorzugt TiWN enthält und für die von der aktiven Schicht 5a emittierte Strahlung absorbierend wirkt, nicht direkt an den Schichtstapel 5 im Bereich der Aussparung der ersten Spiegelschicht 2 angrenzt.

Die zweite Spiegelschicht 8 weist zu dem Schichtstapel 5 einen hohen Kontaktwiderstand auf, während die erste Spiegelschicht 2 einen niedrigen Kontaktwiderstand zu dem Schichtstapel 5 aufweist. Der erhöhte Kontaktwiderstand und die geringe Leitfähigkeit zwischen dem Schichtstapel 5 und der zweiten Spiegelschicht 8 kommt durch eine veränderte Grenzfläche des Schichtstapels 5 im Bereich der Aussparung zustande, so dass die Grenzfläche des Schichtstapels 5 im Bereich der Aussparung nicht elektrisch leitend ist.

Ferner besteht die Möglichkeit, dass durch ein geeignetes Material die zweite Spiegelschicht 8 im Vergleich zur ersten Spiegelschicht 2 eine geringere Leitfähigkeit aufweist.

Da in dem ausgesparten Bereich durch die Änderung der Grenzfläche des Schichtstapels kein elektrischer Kontakt zwischen der zweiten Spiegelschicht 2 und dem angrenzenden Schichtstapel 5 entsteht, wird der Stromfluss zwischen dem Bondpad 6 auf der Strahlungsaustrittsfläche 4 und der zweiten Spiegelschicht 8 in dem Bereich des Schichtstapels 5 der in vertikaler Richtung unterhalb und unmittelbar neben der Kontaktfläche 7 des Bondpads 6 liegt, vermindert. Die Strahlungserzeugung in diesem Bereich der aktiven Schicht 5a ist somit vermindert, wodurch vorteilhaft die Absorption von Strahlung innerhalb des Bondpads 6 reduziert wird.

Die zweite Spiegelschicht 8 enthält vorzugsweise Ag. Alternativ kann die zweite Spiegelschicht 8 Pt enthalten.

Die in Figur 3 dargestellte Dünnfilm-LED unterscheidet sich von der in Figur 2 dargestellten Dünnfilm-LED dadurch, dass die dem Schichtstapel 5 zugewandte Hauptfläche des Bondpads 6 eine reflektierende Schicht 9 aufweist. Die reflektierende Schicht 9 enthält vorzugsweise Ag. Alternativ kann die reflektierende Schicht Al und/oder Pt enthalten.

Die in Figur 3 ausgeführte Dünnfilm-LED weist eine erste Spiegelschicht 2 auf, die als reflektierende Kontaktschicht ausgebildet ist, und die einen dem Bondpad 6 von der aktiven Schicht 5a aus gesehen gegenüberliegenden zweiten elektrischen Kontakt der Dünnfilm-LED ausbildet.

Durch die reflektierende Schicht 9 auf der dem Schichtstapel zugewandten Hauptfläche des Bondpads 6 wird der Anteil der emittierten Strahlung, der von der ersten oder der zweiten Spiegelschicht 2, 8 in Richtung des Bondpads 6 reflektiert wird, von der reflektierenden Schicht 9 zurück in Richtung der ersten und zweiten Spiegelschicht 2, 8 reflektiert. Dieser Anteil der emittierten Strahlung wird wiederum an der ersten oder der zweiten Spiegelschicht 2, 8 in Richtung der Strahlungsaustrittsfläche 4 der Dünnfilm-LED reflektiert und kann durch die Strahlungsaustrittsfläche 4 aus der Dünnfilm-LED ausgekoppelt werden. Auf diese Weise vermindert sich weiter die Absorption von Strahlung in dem Bondpad 6. Bevorzugt wird keine emittierte Strahlung von dem Bondpad 6 absorbiert. Die Effizienz der Dünnfilm-LED erhöht sich vorteilhaft.

Bevorzugt ist die Strahlungsaustrittsfläche 4 der Dünnfilm-LED aufgeraut. Durch diese Aufrauung erniedrigt sich die Reflektivität der Strahlungsaustrittsfläche 4. Dadurch wird ein geringerer Anteil der von der aktiven Schicht emittierten Strahlung an der Strahlungsaustrittsfläche 4 in Richtung der aktiven Schicht 5a zurück reflektiert, wodurch ein größerer Anteil der von der aktiven Schicht emittierten Strahlung an der Strahlungsaustrittsfläche 4 ausgekoppelt wird und sich dadurch die Effizienz der Dünnfilm-LED erhöht.

Die in Figur 4 dargestellte Dünnfilm-LED unterscheidet sich von der Dünnfilm-LED in Figur 3 dadurch, dass die Kontaktstruktur aus einem Bondpad (nicht dargestellt) und Kontaktstegen 10 gebildet ist. Unterhalb der Kontaktstege 10 und dem Bondpad ist die erste Spiegelschicht 2 ausgespart, wobei die laterale Ausdehnung der Aussparungen im Vergleich zur lateralen Ausdehnung der Kontaktfläche der Kontaktstruktur größer ist. Die Grenzfläche des Schichtstapels 5 ist in dem Bereich der Aussparungen der ersten Spiegelschicht 2 derart verändert, dass die Grenzfläche des Schichtstapels im Bereich der Aussparungen nicht elektrisch leitend ist. In den Aussparungen ist jeweils eine zweite Spiegelschicht 8 angeordnet.

Ferner ist im Unterschied zu dem Ausführungsbeispiel aus Figur 3 auf der der ersten und zweiten Spiegelschicht gegenüberliegenden Seite der Barriereschicht eine Kontaktschicht 1 angeordnet, die einen der Kontaktstruktur von der aktiven Schicht 5a aus gesehen gegenüberliegenden zweiten elektrischen Kontakt der Dünnfilm-LED ausbildet.

Durch die Veränderung der Grenzfläche des Schichtstapels 5 in Bereichen der zweiten Spiegelschicht 8 ist die Grenzfläche des Schichtstapels 5 nicht elektrisch leitend, wodurch sich die Lichterzeugung in der aktiven Schicht 5a in Bereichen unterhalb und unmittelbar neben der Kontaktstruktur vermindert. Dadurch ergibt sich eine reduzierte Absorption der von der aktiven Schicht 5a emittierten Strahlung in der Kontaktstruktur.

Die Seitenflächen des Schichtstapels 5 weisen eine weitere reflektierende Schicht 12 auf, die vorzugsweise Ag, Al und/oder Pt enthält. Weiterhin kann auf der Strahlungsaustrittsfläche 4, die keinen Bondpad oder Kontaktstege 10 aufweist, eine Lumineszenzkonversionsschicht 11 aufgebracht sein. Die Lumineszenzkonversionsschicht 11 enthält zumindest einen Lumineszenzkonversionsstoff, der zur Wellenlängenkonversion zumindest eines Teils der von der Dünnfilm-LED emittierten Strahlung zu größeren Wellenlängen hin geeignet ist. Auf diese Weise kann insbesondere mit einer Dünnfilm-LED, die ultraviolette oder blaue Strahlung emittiert, durch Wellenlängenkonversion eines Teils der emittierten Strahlung in den komplementären Spektralbereich, vorzugsweise den gelben Spektralbereich, Weißlicht erzeugt werden.

Die Bereiche des Schichtstapels 5, auf die Kontaktstege 10 aufgebracht sind, weisen bevorzugt eine geringere Schichthöhe auf als Bereiche des Schichtstapels 5, auf die keine Kontaktstege 10 aufgebracht sind. Dadurch kann eine weitere Intensitätssteigerung der von der Dünnfilm-LED emittierten Strahlung erreicht werden. Bevorzugt weist der Schichtstapel 5, auf dem keine Kontaktstege 10 aufgebracht sind, eine Schichthöhe zwischen 4 µm und 8 µm, beispielsweise eine Schichthöhe von 6 µm auf. Die Bereiche des Schichtstapels 5, auf die Kontaktstege 10 aufgebracht sind, weisen bevorzugt eine Schichthöhe zwischen 50 nm und 3,5 µm, beispielsweise eine Schichthöhe von 1 µm auf.

Die Reduzierung der Schichthöhe der Bereiche des Schichtstapels 5, auf die Kontaktstege 10 aufgebracht sind, erfolgt vorzugsweise trockenchemisch. Die Veränderung der Grenzfläche des Schichtstapels 5 erfolgt bevorzugt durch einen Plasmaprozess, besonders bevorzugt durch einen Sputterprozess.

Die Beschreibung der Ausführungsbeispiele ist nicht als Einschränkung auf die Anzahl der einzelnen Schichten zu verstehen. Einzelne Schichten der Dünnfilm-LED können sich ebenso aus einer Schichtenfolge zusammensetzen. Ebenso kann die Dünnfilm-LED zusätzlich zu den oben genannten Schichten beispielsweise Bufferschichten und/oder Zwischenschichten enthalten.

Die Erläuterung des erfindungsgemäßen Dünnfilm-LED anhand der oben beschriebenen Ausführungsbeispiele ist nicht als Beschränkung der Erfindung auf diese zu betrachten. Der Schutzumfang der Erfindung wird durch die angehängten Patentansprüche definiert.

## Patentansprüche

1. Dünnfilm-LED (Light Emitting Diode), umfassend
- eine Barriereschicht (3),
- eine der Barriereschicht (3) nachfolgende erste Spiegelschicht (2),
- einen der ersten Spiegelschicht (2) nachfolgenden Schichtstapel (5), der mindestens eine aktive Schicht (5a) aufweist, die elektromagnetische Strahlung emittiert, und
- mindestens eine dem Schichtstapel (5) nachfolgende Kontaktstruktur (6), die auf einer Strahlungsaustrittsfläche (4) angeordnet ist und die eine Kontaktfläche (7) aufweist, wobei
die Barriereschicht (3) dazu ausgebildet ist, eine Diffusion von Material in die erste Spiegelschicht (2) zu verhindern,
die Barriereschicht (3) TiWN enthält,
die erste Spiegelschicht (2) in einem der Kontaktfläche (7) der Kontaktstruktur (6) gegenüberliegenden Bereich eine Aussparung, die größer als die Kontaktfläche (7) der Kontaktstruktur (6) ist, aufweist, wobei
eine Grenzfläche des Schichtstapels (5), die der Strahlungsaustrittsfläche (4) gegenüber liegt, im Bereich der Aussparung derart verändert ist, dass sich der Kontaktwiderstand zwischen dem Schichtstapel (5) und dem ausgesparten Bereich der ersten Spiegelschicht (2) erhöht, und
die Aussparung der ersten Spiegelschicht (2) eine zweite Spiegelschicht (8) aufweist.

2. Dünnfilm-LED gemäß dem vorhergehenden Anspruch, wobei
die laterale Ausdehnung der Aussparung um 5 µm bis 20 µm größer als die laterale Ausdehnung der Kontaktfläche (7) der Kontaktstruktur (6) ist.

3. Dünnfilm-LED gemäß Anspruch 1, wobei
die Grenzfläche des Schichtstapels (5), die der Strahlungsaustrittsfläche (4) gegenüber liegt, im Bereich der Aussparung derart verändert ist, dass die Grenzfläche des Schichtstapels (5) im Bereich der Aussparung nicht elektrisch leitend ist.

4. Dünnfilm-LED gemäß einem der vorhergehenden Ansprüche, wobei
eine dem Schichtstapel (5) zugewandte Hauptfläche der Kontaktstruktur (6) eine reflektierende Schicht (9) aufweist.

5. Dünnfilm-LED gemäß einem der vorhergehenden Ansprüche, wobei
die Strahlungsaustrittsfläche (4) des Schichtstapels (5) aufgeraut ist.

6. Dünnfilm-LED gemäß einem der vorhergehenden Ansprüche, wobei
die Bereiche des Schichtstapels (5), auf denen die Kontaktstruktur (6) angeordnet ist, eine geringere Schichthöhe aufweisen als Bereiche des Schichtstapels (5), auf denen keine Kontaktstruktur (6) angeordnet ist.

7. Dünnfilm-LED gemäß einem der vorhergehenden Ansprüche, wobei
mindestens eine der Seitenflächen des Schichtstapels (5) eine weitere reflektierende Schicht (12) aufweist.

8. Dünnfilm-LED gemäß einem der vorhergehenden Ansprüche, wobei
auf der Strahlungsaustrittsfläche (4) der Dünnfilm-LED eine Lumineszenzkonversionsschicht (11) aufgebracht ist.

9. Verfahren zur Herstellung einer Dünnfilm-LED gemäß einem der vorhergehenden Ansprüche, mit den folgenden Verfahrensschritten:
- Bereitstellen eines Aufwachssubstrats,
- epitaktisches Aufwachsen eines Schichtstapels (5), der geeignet ist, elektromagnetische Strahlung zu erzeugen,
- Aufbringen einer ersten Spiegelschicht (2), die eine Aussparung in einem Bereich, der einem vorgesehenen Bereich einer Kontaktstruktur (6) gegenüber liegt, aufweist,
- Aufbringen einer zweiten Spiegelschicht (8) in der Aussparung,
- Aufbringen einer Barriereschicht (3) auf der ersten Spiegelschicht (2), wobei die Barriereschicht (3) dazu ausgebildet ist, eine Diffusion von Material in die erste Spiegelschicht (2) zu verhindern und die Barriereschicht (3) TiWN enhält,
- Ablösen des Schichtstapels (5) von dem Aufwachssubstrat,
- Aufbringen einer Kontaktstruktur (6), die eine Kontaktfläche (7) aufweist, auf der der ersten Spiegelschicht (2) gegenüberliegenden Seite des Schichtstapels (5), wobei die Kontaktstruktur (6) in einem der Aussparung der ersten Spiegelschicht (2) gegenüberliegenden Bereich aufgebracht wird, und die Kontaktfläche (7) der Kontaktstruktur (6) kleiner als die Aussparung der ersten Spiegelschicht (2) ist.

10. Verfahren gemäß Anspruch 9, wobei
die Grenzfläche des Schichtstapels (5) vor Aufbringen der Barriereschicht (3) in dem Bereich der Aussparung der ersten Spiegelschicht (2) durch einen Plasmaprozess oder Sputterprozess beschädigt wird.

11. Verfahren gemäß Anspruch 10, wobei
eine zweite Spiegelschicht (8) vor Aufbringen der Barriereschicht (3) in die Aussparung der ersten Spiegelschicht (2) eingebracht wird.

12. Verfahren gemäß einem der Ansprüche 9 bis 11, wobei
die der ersten Spiegelschicht (2) gegenüberliegenden Grenzfläche des Schichtstapels (5) vor Aufbringen der Kontaktstruktur (6) aufgeraut wird.

13. Verfahren gemäß einem der Ansprüche 9 bis 12, wobei vor Aufbringen der Kontaktstruktur (6) auf den Schichtstapel (5) eine reflektierende Schicht (9) auf die Teilbereiche des Schichtstapels (5) aufgebracht wird, die für die Kontaktstruktur (6) vorgesehen sind.

## Claims

1. Light-emitting thin-film diode, comprising
- a barrier layer (3),
- a first mirror layer (2) succeeding the barrier layer (3),
- a layer stack (5) succeeding the first mirror layer (2), which has at least one active layer (5a) which emits electromagnetic radiation, and
- at least one contact structure (6) which succeeds the layer stack (5), is arranged on a radiation exit surface (4) and has a contact surface (7), wherein the barrier layer (3) is designed to prevent diffusion of material into the first mirror layer (2),
the barrier layer comprises TiWN,
the first mirror layer (2) has, in a region lying opposite the contact surface (7) of the contact structure (6), a cutout which is larger than the contact surface (7) of the contact structure (6), wherein
an interface of the layer stack (5) which lies opposite the radiation exit surface (4) is altered in the region of the cutout in such a way that a contact resistance between the layer stack (5) and the cut-out region of the first mirror layer (2) is increased, and
the cutout of the first mirror layer (2) has a second mirror layer (8).

2. Light-emitting thin-film diode according to the preceding claim, wherein
the lateral extent of the cutout is 5 µm to 20 µm larger than the lateral extent of the contact surface (7) of the contact structure (6).

3. Light-emitting thin-film diode according to claim 1, wherein the interface of the layer stack (5), which lies opposite the radiation exit surface (4), is altered in the region of the cutout in such a way that the interface of the layer stack (5) is not electrically conductive in the region of the cutout.

4. Light-emitting thin-film diode according to any of the preceding claims, wherein
a main surface of the contact structure (6) which faces the layer stack (5) has a reflective layer (9).

5. Light-emitting thin-film diode according to any of the preceding claims, wherein
the radiation exit surface (4) of the layer stack (5) is roughened.

6. Light-emitting thin-film diode according to any of the preceding claims, wherein
the regions of the layer stack (5) on which the contact structure (6) is arranged have a smaller layer height than regions of the layer stack (5) on which no contact structure (6) is arranged.

7. Light-emitting thin-film diode according to any of the preceding claims, wherein
at least one of the side surfaces of the layer stack (5) has a further reflective layer (12).

8. Light-emitting thin-film diode according to any of the preceding claims, wherein
a luminescence conversion layer (11) is applied on the radiation exit surface (4) of the light-emitting thin-film diode.

9. Method for producing a light-emitting thin-film diode according to any of the preceding claims, comprising the following method steps:
- providing a growth substrate,
- epitaxially growing a layer stack (5) suitable for generating electromagnetic radiation,
- applying a first mirror layer (2), which has a cutout in a region lying opposite an intended region of a contact structure (6),
- applying a second mirror layer (8) in the cutout,
- applying a barrier layer (3) on the first mirror layer (2), wherein the barrier layer (3) is designed to prevent diffusion of material into the first mirror layer (2) and the barrier layer comprises TiWN,
- stripping the layer stack (5) from the growth substrate,
- applying a contact structure (6), which has a contact surface (7), on the opposite side of the layer stack (5) with respect to the first mirror layer (2), wherein the contact structure (6) is applied in a region lying opposite the cutout of the first mirror layer (2), and the contact surface (7) of the contact structure (6) is smaller than the cutout of the first mirror layer (2).

10. Method according to claim 9, wherein
the interface of the layer stack (5) is damaged before the application of the barrier layer (3) in the region of the cutout of the first mirror layer (2) by means of a plasma process or sputtering process.

11. Method according to Claim 10, wherein
a second mirror layer (8) is introduced into the cutout of the first mirror layer (2) before the application of the barrier layer (3).

12. Method according to any of Claims 9 to 11, wherein
the interface of the layer stack (5) which lies opposite the first mirror layer (2) is roughened before the application of the contact structure (6).

13. Method according to any of Claims 9 to 12, wherein before the contact structure (6) is applied to the layer stack (5), a reflective layer (9) is applied to the partial regions of the layer stack (5) which are intended for the contact structure (6).

## Revendications

1. DEL (diode électroluminescente) à couche mince, comportant:
- une couche barrière (3),
- une première couche miroir (2) succédant à la couche barrière (3),
- un empilement de couches (5) succédant à la première couche miroir (2), comprenant au moins une couche active (5a), émettant un rayonnement électromagnétique, et
- au moins une structure de contact (6) succédant à l'empilement de couches (5) disposée sur une surface de sortie de rayonnement (4) et comportant une surface de contact (7),
la couche barrière (3) étant configurée pour empêcher la diffusion de matériau dans la première couche miroir (2), la couche barrière (3) contenant du TiWN,
la première couche miroir (2) comportant, dans une zone opposée à la surface de contact (7) de la structure de contact (6), un évidement dont les dimensions sont plus grandes que celles de la surface de contact (7) de la structure de contact (6),
dans laquelle
une couche barrière de l'empilement de couches (5) opposée à la surface de sortie (4) étant modifiée au droit de l'évidement de manière que la résistance de contact entre l'empilement de couches (5) et la zone évidée de la première couche miroir (1) devient plus importante, et
l'évidement de la première couche miroir (2) comprenant une seconde couche miroir.

2. DEL à couche mince selon la revendication précédente, dans laquelle
l'extension latérale de l'évidement est supérieure de 5 à 20 microns à l'extension latérale de la surface de contact (7) de la structure de contact (6).

3. DEL à couche mince selon la revendication 1 dans laquelle l'interface de l'empilement de couches (5) faisant face à la surface de sortie de rayonnement (4) est modifiée au droit de l'évidement de manière que l'interface de l'empilement de couches (5) ne soit pas conductrice dans la zone de l'évidement.

4. DEL à couche mince selon l'une des revendications précédentes, dans laquelle
une surface principale de la structure de contact (6) orientée vers l'empilement de couches (5) présente une couche réfléchissante (9).

5. DEL à couche mince selon l'une des revendications précédentes, dans laquelle
la surface de sortie de rayonnement (4) de l'empilement de couches (5) est rendue rugueuse.

6. DEL à couche mince selon l'une des revendications précédentes, dans laquelle
les zones de l'empilement de couches (5) sur lesquelles est disposée la structure de contact (6) présentent une hauteur de couche inférieure à celle de zones de l'empilement de couches (5) sur lesquelles aucune structure de contact (6) n'est disposée.

7. DEL à couche mince selon l'une des revendications précédentes, dans laquelle
au moins l'une des faces latérales de l'empilement de couches (5) comporte une couche réfléchissante (12) supplémentaire.

8. DEL à couche mince selon l'une des revendications précédentes, dans laquelle
une couche de conversion de luminescence (11) est déposée sur la surface de sortie de rayonnement (4) de la DEL à couche mince.

9. Procédé de fabrication d'une DEL à couche mince selon l'une des revendications précédentes, comportant les étapes de procédé suivantes :
- mise à disposition d'un substrat de croissance,
- croissance épitaxiale d'un empilement de couches (5) apte à générer un rayonnement électromagnétique,
- application d'une première couche miroir (2) présentant un évidement dans une zone faisant face à une zone désignée d'une structure de contact (6),
- dépôt d'une seconde couche miroir dans l'évidement,
- dépôt d'une couche barrière (3) sur la première couche miroir (2), la couche barrière (3) étant conçue de manière à éviter la diffusion de matériau dans la première couche miroir (2), et la couche barrière (3) contenant du TiWN,
- détachement de l'empilement de couches (5) du substrat de croissance,
- dépôt d'une structure de contact (6) comportant une surface de contact (7) sur la face de l'empilement de couches (5) faisant face à la première couche miroir (2), la structure de contact (6) étant déposée dans une zone opposée à l'évidement de la première couche miroir (2), et la surface de contact (7) de la structure de contact (6) étant moins grande que l'évidement de la première couche miroir (2).

10. Procédé selon la revendication 9, dans lequel
l'interface de l'empilement de couches (5) est abîmée dans la zone de l'évidement de la première couche miroir (2) moyennant un processus plasma ou un processus de pulvérisation cathodique avant le dépôt de la couche barrière (3).

11. Procédé selon la revendication 10, dans lequel
une seconde couche miroir (8) est introduite dans l'évidement de la première couche miroir (2) avant le dépôt de la couche barrière (3).

12. Procédé selon l'une des revendications 9 à 11, dans lequel
l'interface de l'empilement de couches (5) faisant face à la première couche miroir (2) est rendue rugueuse avant le dépôt de la structure de contact (6).

13. Procédé selon l'une des revendications 9 à 12, dans lequel,
avant le dépôt de la structure de contact (6) sur l'empilement de couches (5), une couche réfléchissante (9) est déposée sur les zones de l'empilement de couches (5) prévues à la structure de contact (6).
